(19) Europäisches Patentamt

European Patent Office

Office européen des brevets

(11) EP 0 725 438 A2

(12) EUROPEAN PATENT APPLICATION

(43) Date of publication:
07.08.1996 Bulletin 1996/32

(51) Int Cl.$^6$: H01L 23/498, H01L 23/538

(21) Application number: 96300664.8

(22) Date of filing: 31.01.1996

(84) Designated Contracting States:
DE FR GB

(30) Priority: 02.02.1995 JP 15732/95

(71) Applicant: SHINKO ELECTRIC INDUSTRIES CO. LTD.
Nagano-shi, Nagano 380 (JP)

(72) Inventors:
• Horiuchi, Michio, c/o Shinko Electric Ind. Co.Ltd.
Nagano-shi, Nagano (JP)

• Takeuchi, Yukiharu,
c/o Shinko Electric Ind.Co.Ltd
Nagano-shi, Nagano (JP)

(74) Representative: Rackham, Stephen Neil
GILL JENNINGS & EVERY,
Broadgate House,
7 Eldon Street
London EC2M 7LH (GB)

(54) Capacitor built-in type substrate

(57) A capacitor built-in type substrate includes a capacitor layer (10) built-in the substrate. The capacitor layer (10) consists of a dielectric layer of aluminum nitride ceramic in which electro-conductive particles are dispersed so that a content of electro-conductive particles dispersed in the dielectric layer is in a range of 5% to 20% by volume. The electro-conductive particles may be nitrides, carbides, or metal.

Fig.2

## Description

The present invention relates to a capacitor built-in type substrate adapted to be used in a semiconductor device, and particularly relates to a capacitor built-in type substrate having a capacitor layer mainly composed of aluminum nitride and capable of being formed together with a substrate body by simultaneous burning. This invention also relates to a method for producing such a capacitor built-in type substrate.

Recently, there has been a trend, in accordance with the speed-up and the densified installation of integrated circuit semiconductor elements, that various properties of a package or a substrate on which electronic elements are installed or accommodated (hereinafter referred to simply as a "substrate" in the meaning that the various packages are totally included) are severely selected. Among such requisites, a problem caused by the increase in heat generation from the element can now to be solved by the development of a substrate composed of a high heat-conductive material, particularly of aluminum nitride ceramic.

On the other hand, the inductance of wirings for a power supply system in the substrate generates a so-called $\Delta$ I (delta I) noise in accordance with the transient variation of electric current upon switching. Particularly, there has recently been an increase in the problem of simultaneous switching noise in a CMOS (complementary metal oxide semiconductor) type logic element, due to the increase in a number of signal treatments, the increase in the current amount relating to the switching and the increase in the clock frequency (i.e., the reduction of switching time).

To solve this problem, a method has been proposed in the prior art wherein a terminal is withdrawn from each of power supply wirings in a substrate to the surface of the substrate and a chip capacitor is connected between the wirings by a soldering. However, such a method is defective because of the increase in the number of parts which results in the high material cost. Also, due to a longer production process, the manufacturing cost becomes still higher. In addition, there is a drawback in that an inductance of the withdrawn part of the wiring has an adverse effect on the substrate performance.

Accordingly, to solve these drawbacks, a method has been proposed to form a high dielectric layer between a power source layer and a ground layer of the substrate and use the same as a capacitor layer.

However, a substrate formed of aluminum nitride ceramic has a low relative dielectric constant of 9 or less, although some of the other properties are favorable, such as a heat-dissipation ability or the like. Therefore, to provide a capacitor layer having a sufficient capacitance using this substrate, it is necessary to extremely reduce the thickness of the capacitor layer, to increase the number of layers and to enlarge the area of the layers. In practice, however, there is a limitation in area and number of the layers in accordance with the substrate size, and there is a restriction in number and thickness of the layers in accordance with a capacity for forming and processing green sheets. Especially, it is deemed difficult to obtain a layer thickness of 50 $\mu$m or less if a mass-production should be more or less taken into consideration.

Accordingly, it has been proposed to use, as a capacitor layer, a material which is different from that of the substrate, but having a high relative dielectric constant. Barium titanate type ceramic is used for the conventionally used chip capacitors. A high relative dielectric constant of several thousands or several ten thousands is obtainable by the above-mentioned ceramic or the like ceramic having a perovskite-like structure.

However, these materials have the following problems due to the difference in their thermal expansion coefficient and optimum firing temperature from those of aluminum nitride which is generally used for a main component of the conventional substrate:

(1) The behavior in contraction and densification during the firing process is not similar between the respective materials. (If the contractions do not start at the same time in the respective materials, or if the magnitudes thereof at the optional temperature are different from each other, strain or crack may occur in the substrate.)
(2) Chemical reaction or permeation may occur between the respective materials.
(3) The material may be reduced under the firing environment for the package. (Since the ordinary package is fired in the weak reducing environment, most of titanate compounds having a high relative dielectric constant are reduced in such a reducing environment and may become different compounds.)
(4) Optimum firing temperatures are not similar between both the materials. (Most of ceramics of a perovskite-like structure having a high relative dielectric constant have an extremely low optimum firing temperature as compared to aluminum nitride ceramic. In practice, aluminum nitride ceramic has the optimum firing temperature in a range between 1700 and 1900°C , while most of titanate compounds have the optimum firing temperature in a range between 1200 and 1400°C.)
(5) A high electro-insulating resistance is not obtainable after firing. (If the reduction occurs as stated before, the electro-insulating property of a titanate compound deteriorates.)

Accordingly, it is impossible to adopt barium titanate or other ceramics of perovskite-like structure, as a material for a dielectric layer of a capacitor layer built into a substrate.

In either case, no material having a high relative dielectric constant has been found for solving all of the above problems.

According to a first aspect of this invention a capacitor built-in type substrate comprises:

a substrate body; and

at least one capacitor layer built-in in said substrate body, said capacitor layer consisting of a dielectric layer of aluminum nitride ceramic in which electro-conductive particles are dispersed so that a content of electro-conductive particles dispersed in said dielectric layer is in a range of not less than 5% by volume and not more than 20% by volume.

Preferably the substrate comprises:

upper and lower substrate layers, each layers consisting essentially of aluminum nitride ceramic; and

at least two of said capacitor layers overlapped to each other and integrally laminated between said upper and lower substrate layers to form a multilayer substrate.

According to a second aspect of this invention a process for producing a capacitor built-in type substrate comprises:

a step of preparing at least one green sheet of a dielectric layer of aluminum nitride ceramic by adding electro-conductive particles thereto in such a manner that said electro-conductive particles are dispersed in said dielectric layer in a range of not less than 5% by volume and not more than 20% by volume; and

a step of firing said green sheet to obtain a sintered body.

The present invention provides a capacitor built-in type substrate, having a high capacitance while maintaining a favorable heat-dissipation ability or others, and which is capable of being easily produced by a simultaneous firing process.

It is preferable that an average size of said electro-conductive particles is not more than 10 $\mu$m. The electro-conductive particles may contain at least one nitride, such as TiN, ZrN, VN, HbN, or TaN, at least one carbide, such as SiC, TiC, ZrC, VC, TaC, $Mo_2C$, and $W_2C$, or at least one metal, such as W or Mo.

With the present invention, since the capacitor layer is formed mainly of aluminum nitride which is the same component of the substrate, the substrate can be easily formed by the simultaneous firing, with high reliability and chemical stability during the bonding of the capacitor layer and during the manufacturing process.

The present invention will be described in more detail with reference to the preferred embodiments illustrated in the attached drawings; wherein

Figure 1 is a graph illustrating the relationship between an amount of titanium nitride powder added in Example 1 and an apparent relative dielectric constant; and

Figure 2 is a cross-sectional view of a substrate according to the present invention.

According to a capacitor built-in type substrate of the present invention, a capacitor layer is built into a substrate base, and the capacitor layer consists of a dielectric layer of aluminum nitride ceramic in which electro-conductive particles are dispersed.

Materials suitable for the electro-conductive particles may be selected from various nitrides, carbides and metals. As the nitrides, TiN, ZrN, VN, NbN and TaN are suitable. As the carbides, SiC, TiC, ZrC, VC, TaC, $Mo_2C$ and $W_2C$ are suitable. As the metals, W and Mo are suitable.

The above-mentioned electro-conductive particles have an average particle size, for example, of 50 $\mu$m or less and are contained in the aluminum nitride ceramic while dispersed therein in a range between 2.0% and 30% by volume. If the content is less than 2.0% by volume, a capacitance obtained becomes insufficient, while if the content is more than 30% by volume, a satisfactory electro-insulating property would not be obtained even though such a property depends on kinds and sizes of the electro-conductive particles used in the capacitance. Preferably, the electro-conductive particles in a range between 5% and 20% by volume are added to the aluminum nitride ceramic.

In the present invention, the effect of the electro-conductive particles mainly relies on the content (percent) thereof by volume. Accordingly, it is favorable to use electro-conductive particles having a smaller specific gravity for reducing a cost and a weight of the product. For example, it is better to use SiC than W, since SiC has a specific gravity of about one sixth of that of W if the same content by volume of electro-conductive particles are added.

Also, by taking the production process into consideration, the electro-conductive particles to be used are restricted. In the production process, the electro-conductive particles of such an amount are first added to a powder of aluminum nitride that a predetermined volume percent thereof is obtained after firing, and a green sheet is molded thereby through a conventional green sheet method. Then, required conductive wirings are arranged both in the vertical and horizontal directions and, after the respective layers are integrally laminated with each other, the green sheet is fired to be a capacitor built-in type aluminum nitride multilayered wiring substrate (capacitor built-in type substrate) according to the present invention.

Accordingly, as the electro-conductive particles, any additives in any state (i.e., oxide, nitride, etc) are allowable to use if they can finally be converted into such particles powder provided that they are finally convertible to have favorable electrical conductivity during firing. For example, it is possible to add metal elements themselves or any oxides which are convertible into the electro-conductive particles to obtain a body in which nitride, carbide or metal is dispersed as the electro-conductive particles after being fired; that is, it is possible to add Ti to obtain a TiN dispersed aluminum nitride substrate, to add W to obtain a $W_2C$ dispersed substrate, and to add $WO_3$ to obtain W dispersed substrate.

Compositions added with such additives may not only be used as a green sheet as mentioned above, but also may be used as a paste.

According to the present invention, since the above-mentioned composition is used for the capacitor layer, it is possible to form the capacitor layer having a high capacitance in a substrate or a package. The composition is mainly composed of the same component as the material of the substrate or the package; that is, aluminum nitride, which is the most important difference of the present invention from the prior art capacitor. Accordingly, in the present invention, it is easy to match the contraction behaviour of the pacKage or the substrate with that of the capacitor layer during the firing process. This is also true to the thermal expansion coefficient when the same is used actually mounted on an electronic apparatus. Also, since aluminum nitride is also used as a main component, the substrate has a high heat-dissipation ability or the like.

The dielectric layer in the capacitor layer contained in the substrate of the present invention has the relative dielectric constant of the same level as that of aluminum nitride which is the main component of the capacitor layer, and is largely different from that of the conventional capacitor. That is; while the conventional capacitor has a relative dielectric constant of at least several tens, generally in a range between several hundreds and several tens of thousands, the dielectric layer in the capacitor layer included in the present invention generally has a relative dielectric constant of 9 or less. A reason why the capacitance can be increased while suppressing the increase of the relative dielectric constant is that the capacitor layer in the present invention acts on electric charges stored between parallel plate electrodes to be basically equivalent to reduce an inter-electrode distance. That is, a capacitance C between parallel plate electrodes is usually represented by the following equation that:

$$C = \varepsilon_o \varepsilon_r \, (S/d)$$

wherein

$\varepsilon_o$ is a dielectric constant in vacuum;
$\varepsilon_r$ is an area of electrode; and
d is an inter-electrode distance.

In this regard, the inter-electrode distance d apparently reduces as an added amount of the electro-conductive particles increases. Accordingly, in the usual capacitance measurement, the measured value varies in accordance with the test piece size, which is apparently larger than that obtained by the calculation based on the actual relative dielectric constant and the test piece size as if the relative dielectric constant became higher. However, in fact, no special substances having a higher relative dielectric constant are generated between the added electro-conductive particles or the precursor thereof and aluminum nitride. It is important that the electro-conductive particles do not react with aluminum nitride and permanently keep their conductivity. If such conditions are satisfied, the same capacitance is obtainable even though the kinds of the electro-conductive particles are different provided that the same volume of such additive is added. Also there is no difference in the resultant capacitance between particle sizes provided that the same volume thereof is added. Accordingly, it is almost no longer necessary to take a particle size into account as far as the capacitance is concerned. However, the size of the electro-conductive particle should be suitably selected because it plays an important role in dispersibility, filling property, green sheet moldability and firing behaviour of the electro-conductive particle. Also a critical amount of electro-conductive particles to be added for the purpose of obtaining a sufficient volume resistance may somewhat vary in accordance with the particle size. Accordingly, an average size of the electro-conductive particles may preferably be 50 $\mu$m or less, and more preferably be 10 $\mu$m or less.

As described above, it was found that the capacitance value of the capacitor layer thus obtained is liable to increase as a total volume of the added electro-conductive particles increases, while the magnitude thereof is larger than that obtained by the calculation under the assumption that the electro-conductive particles are uniformly dispersed with no three-dimensional anisotropy and the capacitance value is equivalent to that of an electro-conductive cube having the same volume, as the added particles, existing between the parallel plate electrodes; and the difference between the two being more significant as the amount of particles increases. This means that the micro-structure of the electro-conductive particles may relate to the increase the capacitance.

Generally speaking, the use of borides as the electro-conductive particles is not desirable even though they are electro-conductive when added or after fired. For example, $TiB_2$ may be thought to be favorable in general because it has an electro-conductive property at a level of 15 $\mu\Omega cm$ in a specific resistance, has a thermal expansion coefficient of $4.6 \times 10^{-6}/°C$ which is well matched with that of aluminum nitride and also has a sufficiently high melting point of 2900°C or more. According to the study of the inventors of the present invention, however, $TiB_2$ has drawbacks in that a product containing $TiB_2$ lacks the structural densification and interferes the achievement of a predetermined capacitance, which causes the increase in DC resistance in the conductive wirings. As a result of X-ray diffraction and EPMA (electron probe microanalysis), it was found that the added $TiB_2$ is nitrided to be TiN. Simultaneously therewith, it was suggested that BN (boron nitride) is generated and part of W in the conductive wiring is converted to WB. Similar tendencies wherein BN and WB are generated accompanied with the nitriding were also recognized in the case of $ZrB_2$ or $LaB_6$. On the other hand, when carbides are added, in accordance with the firing conditions, there may be the problems of high resistance of the conductive wirings and the interference of densification in the structure. Particularly, it is not desirable to add WC or MoC, since a problem of high resistance in the adjacent conductive wirings would occur in the wide firing conditions. It is thought that such substances are converted to $W_2C$ or $Mo_2C$ after being fired to carbonize tungsten in the conductive wirings.

There is no problem in the production of a densified structure when a small amount of SiC is added. However, if the amount increases, the densification is liable to be interfered with, whereby it is necessary to subject the product to severe firing conditions; i.e., the elevation of firing temperature, the increase in firing agent $Y_2O_3$ and the application of pressure in the firing.

While taking the above points; that is, the lower specific gravity and/or the densification; into account, nitrides are preferably added as the electro-conductive particles.

The present invention will now be described in more detail with reference to the following examples:

Example 1

A mixture was prepared by adding a titanium nitride (TiN) powder having an average particle size of about 14 $\mu m$ to a mixture powder of aluminum nitride having an average particle size of about 1 $\mu m$ of 95% by weight and yttrium oxide having an average particle size of about 0.6 $\mu m$ of 5% by weight so that TiN powder is in a range between 5 and 30% by weight (3.1 and 20.7% by volume). 1-butanone, di-n-butylphthalate and acrylic binder were further added thereto and the mixture was mixed in a ball mill for 24 hours and thus green sheets of about 0.2 mm thick were formed. Two of the green sheets were overlapped with each other and integrated into one piece under heat and pressure, which then was fired in dry $N_2$ at a maximum temperature of 1830°C for 5 hours. A density of the resultant fired product was measured. Also, a volume resistance was determined by a 4329A type high resistance tester provided by YHP (Yokogawa Hewlett Packard Co., Ltd.) while using a 16008A type resistor cell provided by HP (Hewlett Packard Co., Ltd.). Also, a capacitance was measured by a 4194A type LCR tester provided by YHP, whereby an apparent relative dielectric constant was obtained. In this regard, DC 50V was applied for 1 minute during the measurement of volume resistance; and a frequency was 1 MHz during the measurement of capacitance.

As a result, as shown in Table 1, until a volume of titanium nitride reaches 16.9%, a densified brown sintered body was obtained, having a sufficient volume resistance of $10^{13}$ $\Omega cm$ or more. If the volume of titanium nitride was 20.7%, although a densified sintered body was obtainable, a volume resistance thereof was too low to be indiscernible by the above tester. According to a four-terminal type resistance tester AX111A provided by ADEX Inc., it was found that the sintered body is conductive, but the volume resistance is 10 $\Omega cm$ or less.

It was found that an apparent relative dielectric constant increases as the volume % of titanium nitride increases and, at the least level, the apparent relative dielectric constant reaches the order of 42 at 16.9% by the volume of titanium nitride. Similar effects were also obtainable by the other nitrides.

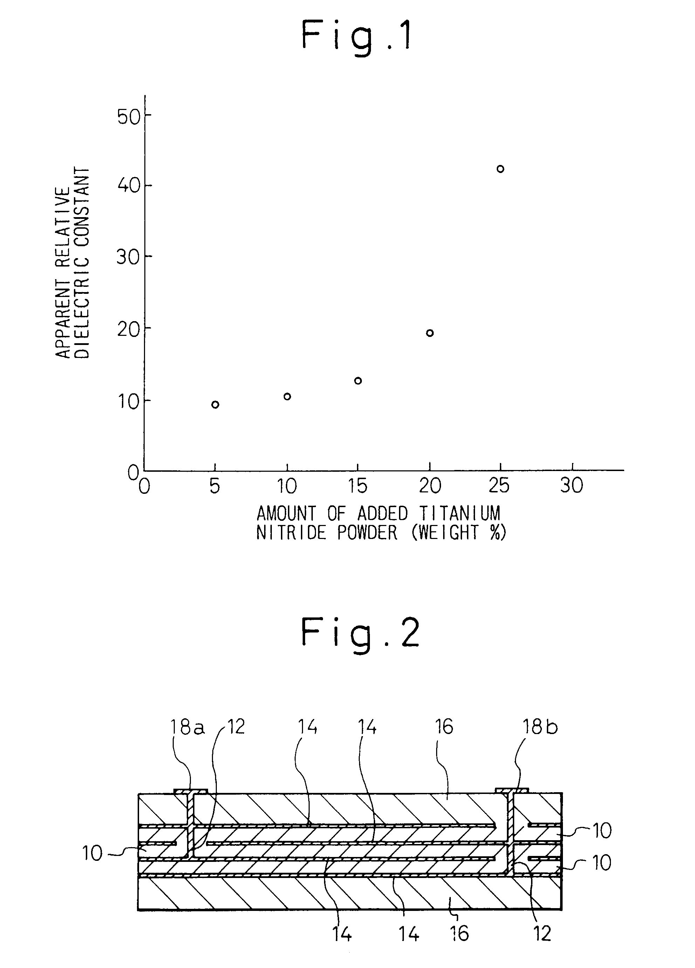

Fig. 1 is a graph wherein data in Table 1 were plotted, representing the relationship between the content of titanium nitride powder and the apparent relative dielectric constant of Example 1.

Table 1

| Sample No. | Additive | Weight | Volume | Density | Volume Resistance | ARDE Const. *) |
|---|---|---|---|---|---|---|
|  |  | % | % | g/cm³ | $\Omega cm$ | in 1 MHz |
| 1 | TiN | 5 | 3.1 | 3.35 | $1.12 \times 10^{14}$ | 9.4 |
| 2 | TiN | 10 | 6.4 | 3.41 | $2.61 \times 10^{14}$ | 10.5 |

*) ARDE Const. : Apparent Relative Dielectric Constant

Table 1 (continued)

| Sample No. | Additive | Weight | Volume | Density | Volume Resistance | ARDE Const. *) |
|---|---|---|---|---|---|---|
| | | % | % | g/cm$^3$ | $\Omega$cm | in 1 MHz |
| 3 | TiN | 15 | 9.3 | 3.48 | $1.43 \times 10^{14}$ | 12.7 |
| 4 | TiN | 20 | 13.0 | 3.58 | $6.69 \times 10^{13}$ | 19.4 |
| 5 | TiN | 25 | 16.9 | 3.60 | $4.49 \times 10^{13}$ | 42.2 |
| 6 | TiN | 30 | 20.7 | 3.60 | < 10 | - |

*) ARDE Const. : Apparent Relative Dielectric Constant

Example 2

A silicon carbide powder having an average particle size of about 3 µm was added to the composition containing aluminum nitride of 95% by weight used in Example 1 so that the content of the silicon carbide is 10% by weight (10.3% by volume). A green sheet was obtained in a similar manner as Example 1, and fired in dry $N_2$ at 1930°C for 5 hours to become a sintered body having a density of 3.07 g/cm$^3$. An apparent relative dielectric constant was 12.1.

As a comparative example to Example 2, a silicon carbide (SiC) powder having an average particle size of about 3 µm was added to the composition containing aluminum nitride of 95% by weight used in Example 1 so that the content of the silicon carbide is 20% by weight (20.5% by volume). A green sheet was obtained in a similar manner as Example 1, and fired in dry $N_2$ at 1830°C for 5 hours to become a grey sintered body, which has not been sufficiently densified, such as to be a density of 2.53 g/cm$^3$, and has a low apparent relative dielectric constant of 8.7.

Example 3

A molybdenum (Mo) powder having an average particle size of about 0.6 µm was added to the composition containing aluminum nitride of 95% by weight used in Example 1 so that the content of the molybdenum is 20% by weight (8.4% by volume) and 30% by weight (13.6% by volume). Green sheets were obtained in a similar manner as Example 1, and fired in dry $N_2$ at 1830°C for 5 hours to be black densified bodies having densities of 3.76 g/cm$^3$ and 4.01 g/cm$^3$, respectively. Apparent relative dielectric constants thereof were 10.8 and 20.6, respectively.

Example 4

A tungsten (W) powder having an average particle size of 0.59 µm was added to the composition containing aluminum nitride of 95% by weight used in Example 1 so that the contents of tungsten were 20%, 40% and 60% by weight (4.1%, 10.3% and 20.5% by volume), respectively. Also tungsten powders having average particle sizes of about 1.11 µm;, 2.0 µm, 3.0 µm, 4.56 µm and 10.0 µm, respectively, were added to the former composition. Green sheet were obtained in a similar manner as Example 1 from the respective mixtures, and fired in dry $N_2$ at 1830°C for 5 hours. As a result, a black densified sintered body was obtained in all cases, as shown in Table 2. In samples containing tungsten of 20% by weight, the variations in apparent relative dielectric constant and volume resistance due to the difference in particle size of tungsten were small (see Table 2). While, in a sample containing tungsten of 60% by weight, a conductivity, such as a volume resistance of 10 $\Omega$cm or less, was obtained.

Table 2

| Sample No. | Additive | PS*[1] | Weight | Volume | Density | Volume Resist | ARDE Const. *[2] |
|---|---|---|---|---|---|---|---|
| | | (µm) | % | % | g/cm$^3$ | $\Omega$cm | in 1 MHz |
| 1 | W | 0.59 | 20 | 4.1 | 3.93 | $8.8 \times 10^{13}$ | 9.8 |
| 2 | W | 1.11 | 20 | 4.1 | 3.93 | $2.23 \times 10^{13}$ | 10.3 |
| 3 | W | 2.0 | 20 | 4.1 | 3.93 | $3.57 \times 10^{13}$ | 9.9 |
| 4 | W | 3.0 | 20 | 4.1 | 3.94 | $2.79 \times 10^{13}$ | 9.9 |
| 5 | W | 4.56 | 20 | 4.1 | 3.94 | $3.72 \times 10^{13}$ | 10.5 |
| 6 | W | 10.0 | 20 | 4.1 | 3.91 | $8.42 \times 10^{13}$ | 9.9 |
| 7 | W | 0.59 | 40 | 10.3 | 4.88 | - | 14.7 |
| 8 | W | 0.59 | 60 | 10.5 | 6.12 | < 10 | - |

*[1]) PS : Average Particle Size,

*[2]) ARDE Const.: Apparent Relative Dielectric Constant

As a comparative example, a green sheet was prepared while solely using the composition containing aluminum nitride of 95% by weight used in Example 1, and fired in dry $N_2$ at 1830°C for 5 hours to obtain a densified sintered body. A relative dielectric constant thereof was 8.9.

Example 5

Green sheets 10 of an inorganic composition consisting of titanium nitride of 20% by weight, yttrium oxide of 4% by weight and aluminum nitride of 76% by weight, having a thickness of about 100 μm were punched with through-holes having a diameter of about 240 μm. After tungsten paste 12 was filled in the through-holes, electrode patterns 14 were screen-printed on one surface of the respective green sheet. After being dried, a pair of green sheets 16 of an inorganic composition consisting of aluminum nitride of 95% by weight and yttrium oxide of 5% by weight, having a thickness of about 400 μm and provided with through-holes filled with tungsten paste, were overlapped with a group of the former green sheets 10 as shown in Fig. 2 and integrated with each other by heating. The intermediate product was fired in dry $N_2$ at 1830°C for 5 hours so that a substrate of about 5 cm square was obtained. Capacitance between terminals 18a and 18b exposed on the outer surface of the substrate was about 11 nF. In this example, the terminal 18a may be used for power supply terminal and the terminal 18b may be used for ground.

According to the capacitor built-in type substrate of the present invention, since a high capacitance is obtainable by a capacitor layer formed mainly of aluminum nitride which is the same component as the substrate, it is possible to solve a noise problem while maintaining a high heat-dissipation property or the like.

Also, since the capacitor layer is mainly formed of aluminum nitride which is the same component as the substrate, it is possible to obtain a high reliability in the chemical stability during the manufacturing process and/or bonding of the capacitor layers. Further, since the capacitor layer is formed by simultaneous firing, the substrate can be easily produced, whereby it is possible to obtain a capacitor built-in type substrate or a package using the same at a low cost and at a high yield.

**Claims**

1. A capacitor built-in type substrate comprising:

   a substrate body; and
   at least one capacitor layer (10) built-in in said substrate body, said capacitor layer (10) consisting of a dielectric layer of aluminum nitride ceramic in which electro-conductive particles are dispersed so that a content of electro-conductive particles dispersed in said dielectric layer is in a range of not less than 5% by volume and not more than 20% by volume.

2. A capacitor built-in type substrate according to claim 1, comprising:

   upper and lower substrate layers (16), each layers consisting essentially of aluminum nitride ceramic; and
   at least two of said capacitor layers (10) overlapped to each other and integrally laminated between said upper and lower substrate layers to form a multilayer substrate.

3. A process for producing a capacitor built-in type substrate comprising:

   a step of preparing at least one green sheet of a dielectric layer of aluminum nitride ceramic by adding electro-conductive particles thereto in such a manner that said electro-conductive particles are dispersed in said dielectric layer in a range of not less than 5% by volume and not more than 20% by volume; and
   a step of firing said green sheet to obtain a sintered body.

4. A process for producing a capacitor built-in type substrate according to claim 3, comprising:

   a step of preparing at least two, first green sheets (16) consisting essentially of aluminum nitride ceramic to form upper and lower substrate layers, respectively;
   a step of preparing at least two, second green sheets of said dielectric layers (10) of aluminum nitride ceramic by adding electro-conductive particles thereto;
   laminating said at least two, second green sheets (10) overlapped to each other and integrally laminated between said at least two, first green sheets (16); and
   a step of simultaneously firing said first and second green sheets to obtain a sintered body.

5. A process according to claim 4, further comprising a step of forming at least one through-hole in at least one of said second green sheets (10) and a step of filling said through-hole with an electrically conductive paste (12), so that said first (16) and second (10) green sheets and said conductive paste (12) are simultaneously fired.

6. A process according to claim 5, further comprising a step of screen-printing at least one electrically conductive pattern (14) on at least one of respective surfaces of at least one of said second green sheets (10), so that said first (16) and second (10) green sheets and said electrically conductive pattern (14) are simultaneously fired.

7. A capacitor built-in type substrate or a process of making it according to any one of the preceding claims, wherein an average size of said electro-conductive particles is not more than 10 μm.

8. A capacitor built-in type substrate or a process of making it according to any of the preceding claims, wherein said electro-conductive particles contain at least one nitride or at least one carbide, or at least one metal.

9. A capacitor built-in type substrate or a process of making it according to claim 8, wherein said at least one nitride is TiN, ZrN, VN, HbN, or TaN, said at least one carbide is SiC, TiC, ZrC, VC, TaC, $Mo_2C$, or $W_2C$, and said at least one metal is W or Mo.

# Fig.1

# Fig.2